# DEMANDE DE BREVET EUROPEEN

(11) **EP 2 738 942 A1**
(43) Date de publication de la demande: **04.06.2014**
(21) Numéro de dépôt: 13194808.5
(22) Date de dépôt: 28.11.2013
(51) Int. Cl.: H03K 19/00, H03K 17/16

(54) **Dispositif d'alimentation à circuit de décharge séquencé**

(30) Priorité: 28.11.2012 FR 1203220
(71) Demandeur: Thales, 92200 Neuilly Sur Seine (FR)
(72) Inventeur: Pubert, Laurent, 49309 Cholet (FR); Gavaud, Sylvain, 49309 Cholet (FR)
(74) Mandataire: Blot, Philippe Robert Emile

(57) **Abrégé**

Le dispositif d'alimentation (10) comporte :
- une entrée principale de commande (40) pour l'activation/désactivation du dispositif d'alimentation ;
- un bloc d'alimentation (22) comportant un circuit de décharge (24) reliant la sortie de puissance (V2) à un potentiel de référence par l'intermédiaire d'un interrupteur commandé (32), et un circuit (26) de commande de l'interrupteur commandé (32) du circuit de décharge (24).

Ce circuit de commande (26) comporte :
- un circuit de temporisation à charge/décharge (62) caractérisé par un temps de relaxation,
- un circuit logique (60 ; 160) dont une entrée est reliée à l'entrée principale de commande (40) du dispositif d'alimentation, et l'autre entrée est reliée à la sortie du circuit de temporisation (62) ; et
- la sortie est reliée à l'interrupteur commandé (32) pour sa commande.

Le premier circuit logique (60) est tel que l'interrupteur commandé (32), est passant seulement lors de la satisfaction des deux conditions suivantes :
- aucun signal d'activation n'est présent sur l'entrée principale de commande (40), et
- la sortie du circuit de temporisation (62) a atteint une valeur au moins égale à celle fournie à l'issue du temps de relaxation.

## Description

La présente invention concerne un dispositif d'alimentation comportant :
- une entrée principale de commande pour l'activation/désactivation du dispositif d'alimentation ;
- un bloc d'alimentation comportant :
   - une entrée de commande pour l'activation/désactivation du bloc d'alimentation en fonction du signal issu de l'entrée principale de commande ;
   - une sortie de puissance propre à fournir un courant d'alimentation lorsque le bloc d'alimentation est activé ;
   - un circuit de décharge reliant la sortie de puissance à un potentiel de référence par l'intermédiaire d'un interrupteur commandé ;
   - un circuit de commande de l'interrupteur commandé du circuit de décharge.

Un équipement électronique comporte couramment un dispositif d'alimentation et une charge alimentée par le dispositif d'alimentation, la charge assurant la fonction de l'équipement électronique.

En dehors de périodes d'utilisation de l'équipement électronique, il est connu de désactiver le dispositif d'alimentation. Du fait de la structure de l'alimentation, la tension à sa sortie ne décroît que très lentement après la désactivation de l'alimentation. Cette tension résiduelle peut être néfaste pour la charge qui reste alimentée. Tel est le cas, lorsque la charge est une matrice à cristaux liquides communément appelée matrice LCD.

Afin d'éviter la persistance de la tension en sortie de l'alimentation désactivée, une première solution consiste à prévoir une charge résistive en sortie de l'alimentation, cette charge résistive assurant une décharge rapide de l'alimentation après désactivation. Cette solution présente toutefois l'inconvénient de maintenir une charge résistive supplémentaire sur la ligne d'alimentation, augmentant ainsi la consommation globale du circuit électrique.

Une autre solution consiste à prévoir un circuit de décharge, ou shunt assurant la liaison de la sortie de l'alimentation à la masse. Ce circuit de décharge est commandé à partir d'un signal différent du signal de désactivation de l'alimentation pour rendre le shunt passant seulement après la désactivation de l'alimentation. II convient alors de disposer d'un séquenceur d'alimentation produisant un signal d'activation/désactivation de l'alimentation et, en synchronisme un signal d'activation/désactivation du shunt de décharge.

Cette solution est relativement coûteuse puisqu'elle nécessite la présence d'un séquenceur propre à fournir les deux signaux de commande.

L'invention a pour but de proposer un dispositif d'alimentation qui soit de structure simple, tout en permettant une réduction de la tension en sortie de l'alimentation après désactivation de celle-ci.

A cet effet, l'invention a pour objet un dispositif d'alimentation du type précité, caractérisé en ce que le circuit de commande comporte :
- un premier circuit de temporisation à charge/décharge caractérisé par un temps de relaxation lors du régime transitoire en présence/absence de signal d'alimentation ;
- un premier circuit logique dont :
- une entrée est reliée à l'entrée principale de commande du dispositif d'alimentation ;
- l'autre entrée est reliée à la sortie du premier circuit de temporisation ; et
- la sortie est reliée à l'interrupteur commandé pour sa commande,
le premier circuit logique étant tel que l'interrupteur commandé, est passant seulement lors de la satisfaction des deux conditions suivantes :
- aucun signal d'activation n'est présent sur l'entrée principale de commande, et
- la sortie du premier circuit de temporisation a atteint une valeur au moins égale à celle fournie à l'issue du temps de relaxation du premier circuit de temporisation.

Suivant des modes particuliers de réalisation, le dispositif d'alimentation comporte l'une ou plusieurs des caractéristiques suivantes :
- le premier circuit logique est une porte OU ;
- le premier circuit logique est une porte ET à deux entrées inverseuses ;
- le circuit de temporisation comporte un condensateur relié entre l'entrée du premier circuit logique et un potentiel de référence et une résistance reliée entre la même entrée du premier circuit logique et l'entrée de commande pour l'activation/désactivation du bloc d'alimentation ;
- ledit dispositif comporte :
   - un second circuit de temporisation à charge/décharge caractérisé par un temps de relaxation lors du régime transitoire en présence/absence de signal d'alimentation,
   - un second circuit logique dont :
      - une entrée est reliée à l'entrée principale de commande du dispositif d'alimentation ;
      - l'autre entrée est reliée à la sortie du second circuit de temporisation ; et
      - la sortie est reliée à l'entrée de commande pour l'activation/désactivation du bloc d'alimentation ;
   - le second circuit logique étant tel que l'entrée de commande du bloc d'alimentation reçoit un signal d'activation seulement lors de la satisfaction des deux conditions suivantes :
      - un signal d'activation est présent sur l'entrée principale de commande ; et
      - la sortie du second de temporisation a atteint une valeur au moins égale à celle fournie à l'issue du temps de relaxation du second circuit de temporisation ;
- le second circuit logique est une porte ;
- le second circuit logique est une porte ET à une entrée inverseuse ;
- le circuit de temporisation comporte un condensateur relié entre l'entrée du second circuit logique et un potentiel de référence et une résistance reliée entre la même entrée du circuit logique et la sortie du premier circuit logique ;
- le circuit de décharge comporte une résistance en série avec l'interrupteur commandé ;
- ledit dispositif comporte une porte inverseuse disposée entre la sortie du premier circuit logique et l'interrupteur commandé.

L'invention sera mieux comprise à la lecture de la description qui va suivre, donnée uniquement à titre d'exemple et faite en se référant aux dessins sur lesquels :
- la figure 1 est une vue partiellement schématique d'un équipement électronique comportant un dispositif d'alimentation selon l'invention ;
- la figure 2 est un chronogramme illustrant les états en différents points du circuit de la figure 1 ; et
- la figure 3 est une vue identique à celle de la figure 1 d'un autre mode de réalisation d'un équipement électronique comportent un dispositif d'alimentation selon l'invention.

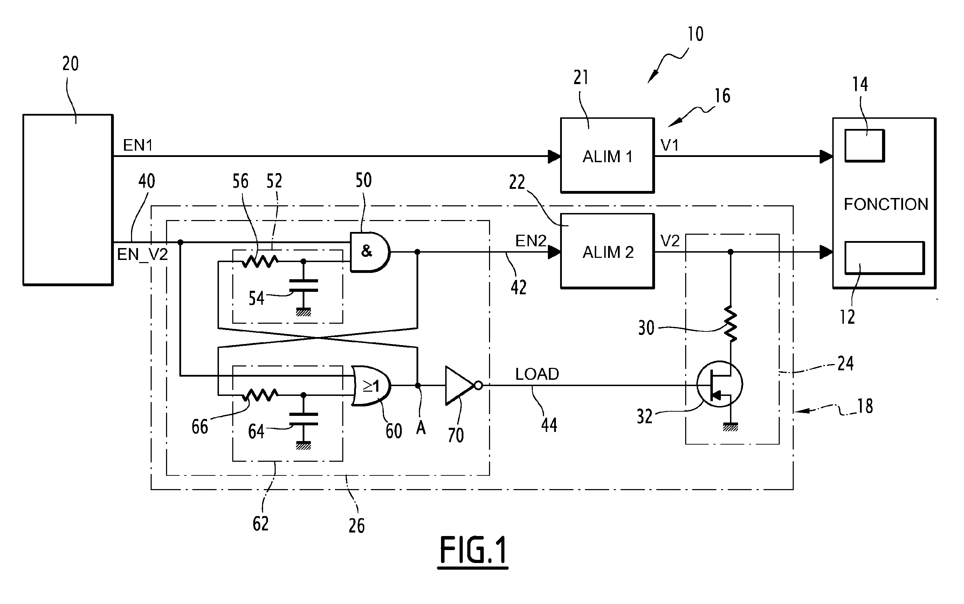

L'équipement électronique 10 illustré sur la figure 1 est par exemple un écran LCD. Cet écran comporte une matrice ou dalle LCD 12 ainsi qu'un circuit 14 de contrôle de la dalle LCD.

Le circuit de contrôle 14 est relié pour son alimentation à un premier dispositif d'alimentation 16 alors que la matrice LCD 12 est reliée à un second dispositif d'alimentation 18 distinct. Les dispositifs d'alimentation 16 et 18 sont propres à fournir en sortie lorsqu'ils sont activés une tension respectivement égale à V1 et V2 adaptée au circuit dont ils assurent l'alimentation.

L'écran LCD 10 comporte enfin un synchronisateur 20 propre à commander les dispositifs d'alimentation 16 et 18 et en particulier propres à fournir un signal EN1 pour l'activation/désactivation du dispositif d'alimentation 16 et un signal EN_V2 pour l'activation/désactivation du dispositif d'alimentation 18.

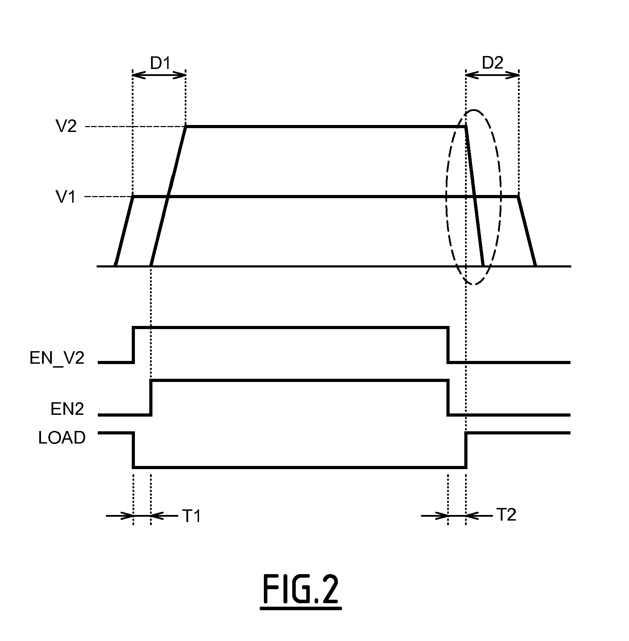

Le synchronisateur 20 est adapté pour, lors de la mise sous tension de l'écran LCD, d'abord activer le dispositif d'alimentation 16 puis, seulement quelques instants après, activer le dispositif d'alimentation 18 de la matrice LCD 12 de sorte que la tension V1 s'établit avant la tension V2 comme illustré sur la figure 2. Le décalage temporel est indiqué par D1.

De même, lors de l'extinction de l'écran LCD, le synchroniseur 20 est propre à commander la désactivation du dispositif d'alimentation 18 avant la désactivation du dispositif d'alimentation 16 avec un décalage temporel noté D2 visible sur la figure 2.

Les dispositifs d'alimentation 16 et 18 sont activés lorsque les signaux d'activation/ désactivation respectivement EN1 et EN_V2 sont égaux à 1 et désactivés lorsque les signaux d'activation/désactivation EN1 et EN_V2 sont égaux à 0.

Le dispositif d'alimentation 16 comporte un bloc d'alimentation 21 recevant directement en entrée le signal de commande EN1 et fournissant en sortie le courant d'alimentation appliqué directement au circuit de contrôle 14.

Le bloc d'alimentation 21 est par exemple une alimentation régulée linéaire.

Le dispositif d'alimentation 18 comporte un bloc d'alimentation 22 formé par exemple d'une alimentation à découpage type Boost, connue sous l'expression anglaise « step-up DC/DC converter ». La sortie du bloc d'alimentation 22 forme la sortie du dispositif d'alimentation 18. Ainsi l'entrée de la dalle 12 est reliée directement en sortie du bloc d'alimentation 22 sans interposition d'une résistance montée en série.

Le dispositif d'alimentation 18 comporte en outre un shunt ou circuit de décharge 24 de la sortie d'alimentation du bloc 22 et un circuit 26 de commande du circuit de décharge 24 à partir du même signal d'activation/désactivation du dispositif d'alimentation 18 noté EN_V2. Selon l'invention, le circuit de commande 26 est dépourvu de calculateurs programmables et ne comporte que des éléments logiques passifs et des composants discrets.

Le circuit de décharge 24 comporte, montés en série entre la sortie du bloc d'alimentation 22 formant la sortie du dispositif d'alimentation 18 et la masse, une résistance de décharge 30 et un transistor MOSFET 32 propre à assurer la liaison sélective de la résistance 30 à la masse. La grille de commande du transistor 32 est reliée à une sortie de commande du circuit de commande 26 dont le signal de commande est désigné par LOAD.

Le circuit de commande 26 comporte une unique entrée 40 connectée à la sortie du séquenceur 20 pour recevoir le signal d'activation/désactivation EN_V2. Il comporte une sortie 42 reliée à l'entrée de commande du bloc d'alimentation 22 propre à adresser au bloc d'alimentation un signal d'activation/désactivation noté EN2. La seconde sortie 44 du circuit de commande est propre à fournir la commande LOAD de pilotage du transistor 32.

Le bloc d'alimentation 22 est propre à être activé lorsque le signal EN2 est égal à 1 et désactivé lorsque le signal EN2 est égal à 0.

L'entrée 40 du circuit de commande 26 est reliée à une première entrée d'une porte ET 50 dont la sortie constitue la sortie 42 du circuit de commande 26. L'autre entrée de la porte ET 50 est reliée à un circuit RC de temporisation 52. Le circuit 52 comporte un condensateur 54 relié entre la seconde entrée de la porte ET et la masse ainsi qu'une résistance de charge/décharge 56 dont une des bornes est reliée entre la seconde entrée de la porte ET 50 et le condensateur 54. Le circuit de temporisation présente en mode transitoire un temps de relaxation défini par les valeurs de la résistance et du condensateur en cas de rupture d'alimentation ou en cas de début d'alimentation.

Le circuit de commande 26 comporte une porte OU 60 dont une première entrée est reliée directement à l'entrée 40 et dont la seconde entrée est reliée à un circuit RC de temporisation 62.

Ce circuit 62 comporte comme le circuit 52 un condensateur 64 disposé entre la masse et la seconde entrée du circuit OU 60 ainsi qu'une résistance de charge/décharge 66 dont une borne est reliée entre le condensateur 64 et la seconde entrée du circuit OU 60.

La sortie du circuit OU 60 est reliée à la grille de commande du transistor 32 par l'intermédiaire d'une porte NON 70 formant un inverseur. La sortie de l'inverseur 70 constitue la sortie 44 du circuit de commande 26.

Les secondes bornes des résistances 56, 66 sont reliées respectivement à la sortie de la porte OU 60 et à la sortie de la porte ET 50.

Le fonctionnement de l'équipement électronique va maintenant être décrit. Les différents états du circuit de commande 26 sont illustrés ci-dessous dans la table de vérité 1 et seront détaillés dans la suite de la description. La valeur A correspond à la valeur de la sortie de la porte OU 60.

**Table de vérité 1**

| EN_V2 | A | EN2 | LOAD | Commentaire |
|---|---|---|---|---|
| 0 | 0 | 0 | 1 | La tension V2 est déchargée via R₃₀ |
| 1 | 1 | 0 | 0 | Le shunt R₃₀ de la tension V2 est relâché |
| 1 | 1 | 1 | 0 | La tension V2 est active |
| 0 | 1 | 0 | 0 | La tension V2 est non active |
| 0 | 0 | 0 | 1 | La tension V2 se décharge via R₃₀ |

Lors de la mise sous tension de l'équipement, le séquenceur 20 assure comme illustré sur la figure 2 d'abord l'établissement de la tension V1 puis le signal EN_V2 passe à1.

Tant que le signal EN_V2 est égal à 0, les condensateurs 54 et 64 étant déchargés, le bloc d'alimentation 22 est désactivé, le signal EN2 étant nul alors que le circuit de décharge 24 est activé, le signal LOAD étant égal à 1.

Lorsque le signal EN_V2 passe à 1 après établissement de la tension V1, la sortie de la porte OU 60 passe à 1, conduisant un blocage du transistor 32, le signal LOAD prenant la valeur 0. Ainsi, la sortie du bloc d'alimentation 22 est d'abord déconnectée de la masse.

La sortie de la porte OU 60 étant égale à 1, le condensateur 54 se charge progressivement au travers de la résistance 56. Lorsque la tension aux bornes du condensateur 54 devient supérieure à un seuil prédéterminé propre à la porte ET 50, la porte ET 50 passe à 1, les deux entrées de la porte ET 50 étant égales à 1. Cette période de temps correspond au temps de relaxation propre au circuit et est notée T1 sur la figure 2. Dès que le signal EN2 est égal à 1, le bloc d'alimentation 22 est activé et voit sa tension de sortie V2 augmenter pour atteindre la tension V2 à l'issue de la période de temps D1. De même, le condensateur 64 se charge au travers de la résistance 66 pour appliquer une valeur 1 en entrée de la porte OU 60.

Pour l'arrêt de l'écran d'affichage, le séquenceur 20 passe d'abord le signal EN_V2 à 0 de sorte que le signal EN2 en sortie de la porte ET 50 revient immédiatement nul provoquant la désactivation du bloc d'alimentation 22.

Le condensateur 64 étant chargé, du fait de son alimentation pendant toute la période précédente au cours de laquelle le signal EN2 était égal à 1, la sortie de la porte OU 60 reste temporairement à l'état 1, même lorsque le signal EN_V2 est égal à 0, conduisant à maintenir le transistor 32 à l'état bloqué, le signal de commande LOAD étant égal à 0.

Le condensateur 64 se décharge alors progressivement au travers de la résistance 66, la valeur EN2 étant nulle.

Lorsque le condensateur 64 est suffisamment déchargé et en une tension inférieure à une tension prédéterminée propre à la porte OU 60, les deux entrées de la porte OU 60 sont égales à 0, basculant ainsi la sortie A à 0 ce qui provoque le basculement du transistor 32 à son état passant, la valeur LOAD étant égale à 1.

Ainsi, après une période de temps T2 suivant le basculement du signal EN_V2 à 0, correspondant au temps de relaxation du circuit 62, la tension de sortie du bloc d'alimentation 22 chute jusqu'à 0, par circulation du courant au travers de la résistance de décharge 30.

Après une durée D2, le bloc d'alimentation 21 est commandé pour être désactivé, la valeur EN1 étant mise à 0 par le séquenceur.

On conçoit qu'avec un tel dispositif d'alimentation 18, il est possible à partir d'un unique signal de d'activation/désactivation EN_V2 d'assurer à partir de circuits logiques simples et de circuits RC passifs une synchronisation entre l'activation/désactivation du bloc d'alimentation 22 et une mise à la masse au travers d'une résistance de décharge 30 de la sortie du bloc d'alimentation.

Cette solution est donc particulièrement économique et fiable.

En variante, les circuits de temporisation RC sont remplacés par des circuits RL ou RLC.

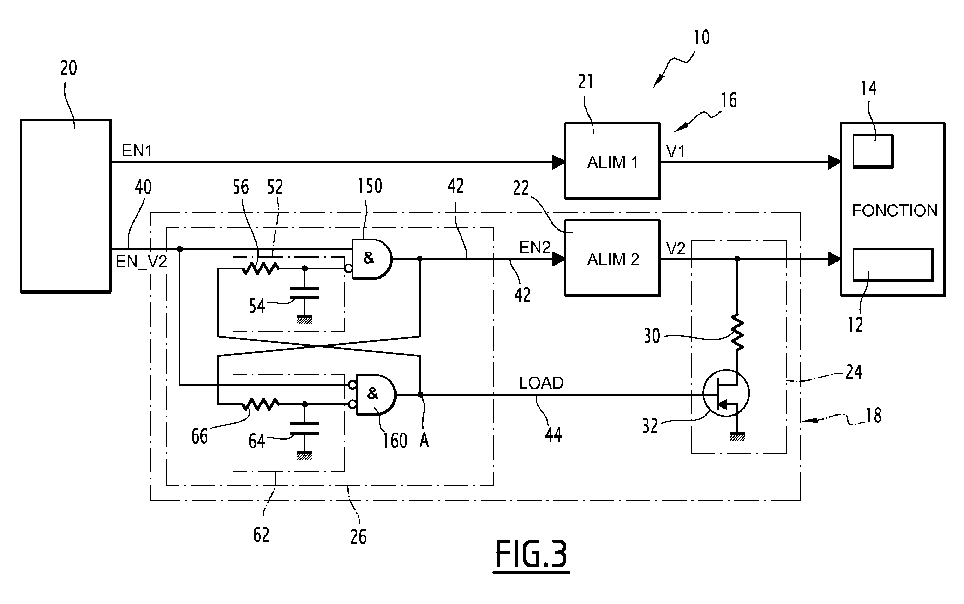

Sur la figure 3 est représentée une variante de réalisation du dispositif d'alimentation 10. Sur cette figure, les éléments identiques ou correspondants à ceux de la figure 1 sont désignés par les mêmes numéros de référence.

Dans ce mode de réalisation, l'inverseur 70 est supprimé et la porte ET 50 est remplacée par une porte ET 150 dont la seconde entrée connectée au circuit de retardement 52 est inverseuse. De même, la porte OU 60 est remplacée par une porte ET 160 dont les deux entrées sont inverseuses.

La table de vérité 2 du circuit de commande 26 est illustrée ci-dessous. Le séquencement des signaux EN_V2, EN2 et LOAD est identique à celui du premier mode de réalisation, seul l'état au point A étant opposé.

**Table de vérité 2**

| EN_V2 | A | EN2 | LOAD | Commentaire |
|---|---|---|---|---|
| 0 | 1 | 0 | 1 | La tension V2 est déchargée via R₃₀ |
| 1 | 0 | 0 | 0 | Le shunt R₃₀ de la tension V2 est relâché |
| 1 | 0 | 1 | 0 | La tension V2 est active |
| 0 | 0 | 0 | 0 | La tension V2 est non active |
| 0 | 1 | 0 | 1 | La tension V2 se décharge via R₃₀ |

Ce mode de réalisation présente l'avantage de comporter une porte logique de moins réduisant encore le coût de fabrication.

Dans ce mode de réalisation, initialement le condensateur 54 est chargé. En effet, à la mise sous tension, quelque soit la valeur de la charge des condensateurs 54 et 64, le signal EN_V2 vaut 0 donc la sortie de la porte ET 150 vaut 0. La sortie de la porte ET 160 peut être à 0 ou 1 (le shunt 24 peut être activé). Le condensateur 64 est forcé en décharge, la sortie de la porte ET 160 est donc forcée à 1. De ce fait le condensateur 54 se charge et le condensateur 64 est déchargé. Lorsque le signal EN_V2 passe à 1, l'interrupteur 32 est ouvert immédiatement, l'entrée à la porte 160 reliée à l'entrée 40 passant à 1.

Le signal EN2 reste à 0 puisque l'entrée reliée à la porte ET 150 reste égale à 1, le condensateur 54 étant chargé.

Progressivement, le condensateur 54 se décharge au travers de la résistance 56, la sortie de la porte ET 160 étant à 0. Après une décharge suffisante, le signal EN2 passe à1.

Le condensateur 64 se charge alors progressivement. Après une charge suffisante, la sortie de la porte ET 160 est maintenue à 0.

Lors de la désactivation du dispositif d'alimentation par passage à 0 de EN_V2, le signal EN2 passe à 0 désactivant le bloc d'alimentation 22 et le condensateur 64 se décharge progressivement au travers de la résistance 66 jusqu'à atteindre une tension au dessous de laquelle la sortie de la porte 160 passe à 1, activant ainsi de manière différée le circuit de décharge 24.

## Revendications

1. Dispositif d'alimentation (10) comportant :
- une entrée principale de commande (40) pour l'activation/désactivation du dispositif d'alimentation ;
- un bloc d'alimentation (22) comportant :
- une entrée de commande (42) pour l'activation/désactivation du bloc d'alimentation (22) en fonction du signal issu de l'entrée principale de commande (40) ;
- une sortie de puissance (V2) propre à fournir un courant d'alimentation lorsque le bloc d'alimentation (22) est activé ;
- un circuit de décharge (24) reliant la sortie de puissance (V2) à un potentiel de référence par l'intermédiaire d'un interrupteur commandé (32) ; et
- un circuit (26) de commande de l'interrupteur commandé (32) du circuit de décharge (24),
**caractérisé en ce que** le circuit de commande (26) comporte :
- un premier circuit de temporisation à charge/décharge (62) **caractérisé par** un temps de relaxation lors du régime transitoire en présence/absence de signal d'alimentation ;
- un premier circuit logique (60 ; 160) dont :
- une entrée est reliée à l'entrée principale de commande (40) du dispositif d'alimentation ;
- l'autre entrée est reliée à la sortie du premier circuit de temporisation (62) ; et
- la sortie est reliée à l'interrupteur commandé (32) pour sa commande,
le premier circuit logique (60) étant tel que l'interrupteur commandé (32), est passant seulement lors de la satisfaction des deux conditions suivantes :
- aucun signal d'activation n'est présent sur l'entrée principale de commande (40), et
- la sortie du premier circuit de temporisation (62) a atteint une valeur au moins égale à celle fournie à l'issue du temps de relaxation du premier circuit de temporisation (62).

2. Dispositif d'alimentation (10) selon la revendication 1, **caractérisé en ce que** le premier circuit logique est une porte OU (60).

3. Dispositif d'alimentation (10) selon la revendication 1, **caractérisé en ce que** le premier circuit logique est une porte ET (160) à deux entrées inverseuses.

4. Dispositif d'alimentation (10) selon l'une quelconque des revendications précédentes, **caractérisé en ce que** le circuit de temporisation (62) comporte un condensateur (64) relié entre l'entrée du premier circuit logique (60 ; 160) et un potentiel de référence et une résistance (66) reliée entre la même entrée du premier circuit logique (60 ; 160) et l'entrée de commande (42) pour l'activation/désactivation du bloc d'alimentation (22).

5. Dispositif d'alimentation (10) selon l'une quelconque des revendications précédentes, **caractérisé en ce qu'**il comporte :
- un second circuit de temporisation à charge/décharge (52) **caractérisé par** un temps de relaxation lors du régime transitoire en présence/absence de signal d'alimentation,
- un second circuit logique (50 ; 150) dont :
- une entrée est reliée à l'entrée principale de commande (40) du dispositif d'alimentation ;
- l'autre entrée est reliée à la sortie du second circuit de temporisation (52) ; et
- la sortie est reliée à l'entrée de commande (42) pour l'activation/désactivation du bloc d'alimentation (22) ;
- le second circuit logique (50 ; 150) étant tel que l'entrée de commande (42) du bloc d'alimentation (22) reçoit un signal d'activation seulement lors de la satisfaction des deux conditions suivantes :
- un signal d'activation est présent sur l'entrée principale de commande (40) ; et
- la sortie du second de temporisation (52) a atteint une valeur au moins égale à celle fournie à l'issue du temps de relaxation du second circuit de temporisation (52).

6. Dispositif d'alimentation (10) selon la revendication 5, **caractérisé en ce que** le second circuit logique est une porte ET (50).

7. Dispositif d'alimentation (10) selon la revendication 5, **caractérisé en ce que** le second circuit logique est une porte ET à une entrée inverseuse (150).

8. Dispositif d'alimentation (10) selon l'une quelconque des revendications 5 à 7, **caractérisé en ce que** le circuit de temporisation (52) comporte un condensateur (54) relié entre l'entrée du second circuit logique (50 ; 150) et un potentiel de référence et une résistance (56) reliée entre la même entrée du circuit logique (50 ; 150) et la sortie du premier circuit logique (50 ; 150).

9. Dispositif d'alimentation (10) selon l'une quelconque des revendications précédentes, **caractérisé en ce que** le circuit de décharge (24) comporte une résistance (30) en série avec l'interrupteur commandé (32).

10. Dispositif d'alimentation selon une quelconque des revendications précédentes, **caractérisé en ce qu'**il comporte une porte inverseuse (70) disposée entre la sortie du premier circuit logique (60) et l'interrupteur commandé (32).
